# FASCICULE DE BREVET EUROPEEN

(11) **EP 2 920 653 B1**
(45) Date de publication et mention de la délivrance du brevet: **30.07.2025**
(21) Numéro de dépôt: 13774213.6
(22) Date de dépôt: 10.10.2013
(51) Int. Cl.: G04B 17/22, B23K 26/06, F16F 1/10, H03H 9/02

(54) **RÉSONATEUR MOINS SENSIBLE AUX VARIATIONS CLIMATIQUES**
RESONATOR, DER WENIGER EMPFINDLICH GEGENÜBER KLIMATISCHEN SCHWANKUNGEN IST
RESONATOR THAT IS LESS SENSITIVE TO CLIMATE VARIATIONS

(30) Priorité: 16.11.2012 EP 12193057
(43) Date de publication de la demande: 23.09.2015
(73) Titulaire: Nivarox-FAR S.A., CH-2400 Le Locle (CH)
(72) Inventeur: CUSIN, Pierre, CH-1423 Villars-Burquin (CH); HESSLER, Thierry, CH-2024 St-Aubin (CH); SALIHU, Fatmir, CH-2000 Neuchâtel (CH); BROCHER, Lucie, CH-1950 Sion (CH); TRAN, Hung Quoc, CH-2504 Bienne (CH)
(74) Mandataire: Collé, Emmanuel
(86) Numéro de dépôt international: PCT/EP2013/071214
(87) Numéro de publication internationale: WO 2014/075859

(56) Documents cités:
- EP-A1- 2 590 325
- EP-A2- 1 837 722
- WO-A1-2007/000271
- CH-A2- 699 780
- CH-A2- 702 353
- CN-A- 102 032 302
- DE-A1- 102009 031 841
- US-A1- 2011 292 770

## Description

### Domaine de l'invention

L'invention se rapporte à un résonateur balancier-spiral compensé thermiquement dont le spiral compensateur est moins sensible aux variations climatiques.

### Arrière-plan de l'invention

Lors de tests de condensation sévères sur des mouvements horlogers, il est apparu que la marche pouvait être influencée.

CH 702 353 A2 divulgue un spiral formé avec une âme en silicium monocristallin ou en quartz et recouvert de dioxyde de silicium et de dioxyde de germanium.

DE 10 2009 031841 A1 se réfère à un ressort-spiral avec une âme en silicium préférablement en silicium polycristallin. Un élément fonctionnel en silicium couvert par une couche en dioxyde de silicium sur laquelle une couche métallique en Nitride de Titane et/ou en Carbide de Titane est déposée, le tout étant protégé par une couche finale en DLC.

### Résumé de l'invention

Le but de la présente invention est de pallier tout ou partie les inconvénients cités précédemment en proposant un spiral non métallique qui est moins sensible aux variations climatiques.

A cet effet, un spiral compensateur pour un résonateur balancier-spiral compensé thermiquement comporte une âme formée à partir d'au moins un matériau non métallique comporte du quartz ou du silicium dopé ou non sur lequel est formé au moins partiellement un revêtement de dioxyde de silicium caractérisé en ce que l'âme est entièrement revêtue d'une couche qui est résistante et imperméable à l'humidité afin de rendre le spiral compensateur moins sensible aux variations climatiques.

On comprend donc que le spiral compensateur même en cas de condensation sévère sera peu perturbé dans son fonctionnement afin que le fonctionnement global du résonateur qu'il forme en coopération avec un balancier ne soit pas ou peu influencé.

Conformément à d'autres caractéristiques :
- la couche résistante et imperméable à l'humidité comporte une épaisseur inférieure à 50 nm ;
- la couche résistante et imperméable à l'humidité est en chrome, en titane ou en tantale ;
De plus, un résonateur compensé thermiquement pour une pièce d'horlogerie comporte un balancier caractérisé en ce que le balancier coopère avec un spiral compensateur selon une quelconque des variantes précédentes.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est un spiral compensateur**;**
- les figures 2 à 7 sont des variantes de section de spiral compensateur selon l'invention.

### Description détaillée des modes de réalisation préférés

Une étude a été menée afin de déterminer le comportement des mouvements horlogers d'une pièce d'horlogerie en fonction de condensations sévères. L'étude a été menée en forçant le point de rosée à être dépassé brutalement par exemple en maintenant un taux d'hygrométrie supérieur à 80% et en diminuant la température d'au moins 15°C.

Il a été montré que la marche d'une pièce d'horlogerie pouvait être influencée notamment pour le cas où le spiral compensateur d'un résonateur balancier-spiral est formé au moins partiellement à partir d'un oxyde de silicium cristallin ou amorphe. Un tel spiral compensateur peut être formé par exemple à partir de silicium cristallin dopé ou non sur lequel est formé au moins partiellement un revêtement de dioxyde de silicium ou encore à partir de quartz.

L'étude a également montré que l'influence de ces condensations sévères peut être minimisée par une barrière à l'humidité formée sur le spiral compensateur comportant un oxyde de silicium cristallin ou amorphe.

Par conséquent, un spiral compensateur pour un résonateur balancier-spiral compensé thermiquement comporte une âme formée à partir d'au moins un matériau non métallique. Avantageusement, l'âme est entièrement revêtue d'une couche qui est stable à l'humidité, c'est-à-dire résistante et imperméable à l'humidité, afin de rendre le spiral compensateur moins sensible aux variations climatiques.

La couche stable à l'humidité comporte une épaisseur inférieure à 50 nm et préférentiellement comprise autour de 10 nm afin de ne pas influencer mécaniquement le fonctionnement du spiral. Toutefois, l'épaisseur de la couche stable à l'humidité peut atteindre jusqu'au quelques micromètres, mais doit, dans ce cas, être prise en compte pour la compensation thermique du résonateur balancier-spiral.

De plus, il est préféré que la couche stable à l'humidité soit électriquement conductrice et faiblement sensible aux champs magnétiques comme par exemple diamagnétique ou paramagnétique.

A titre d'exemple, la couche stable à l'humidité peut ainsi comporter du chrome, du titane, du tantale, de l'aluminium, du zirconium, de l'alumine, de l'oxyde de chrome, du chrome tungstène, du PTE ou du nitrure de silicium (Si₃N₄). Selon l'invention revendiquée, le chrome, le titane, le tantale ou un de leurs alliages sont considérés parce qu'ils ont montré les meilleurs résultats.

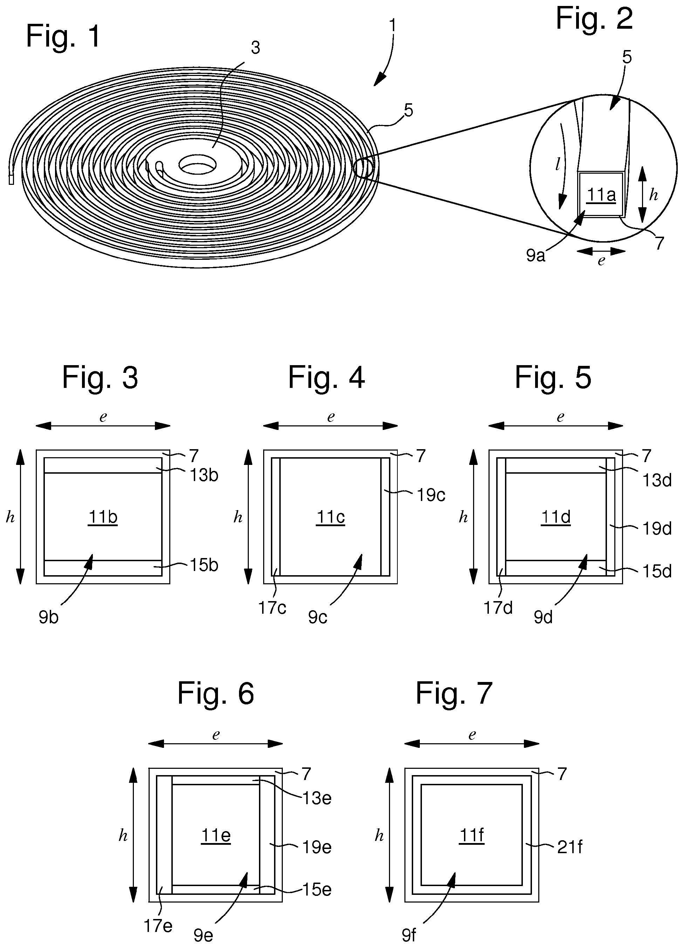

Les figures 1 à 7 présentent des variantes d'un spiral 1 destiné à compenser thermiquement le résonateur qu'il forme en coopération avec un balancier. Le spiral compensateur 1 comporte une virole 3 venue de forme avec la lame 5 enroulée selon plusieurs spires. Au moins la lame 5 du spiral compensateur 1 est revêtue d'une couche 7 qui forme une barrière à l'humidité.

La lame 5 comporte une longueur *l,* une épaisseur e et une hauteur *h.* Elle comporte une âme 9a, 9b, 9c, 9d, 9e, 9f formée à partir d'au moins un matériau 11a, 11b, 11c, 11d, 11e, 11f.

Selon les variantes des figures 2 à 7, l'âme 9a, 9b, 9c, 9d, 9e, 9f peut être formée à partir d'au moins un unique matériau 11a, 11b, 11c, 11d, 11e, 11f comprenant du silicium ou à partir de plusieurs matériaux 11a, 11b, 11c, 11d, 11e, 11f, 13d, 15d, 17d, 19d, 13e, 15e, 17e, 19e, 21f, 13b, 15b, 17c, 19c, comprenant du quartz.

Lorsque l'âme 9b, 9c, 9d, 9e, 9f est formée à partir de plusieurs matériaux 11a, 11b, 11c, 11d, 11e, 11f, 13b, 15b, 17d, 19d, 13e, 15e, 17e, 19e, 21f, 13b, 15b, 17c, 19c, elle peut être entièrement enrobée 13d, 15d, 17d, 19d, 13e, 15e, 17e, 19e, 21f ou partiellement enrobée 13b, 15b, 11c, 17c, 19c, de plusieurs matériaux avant que la lame 5 du spiral 1 soit revêtue d'une couche 7 qui est stable à l'humidité, c'est-à-dire résistante et imperméable à l'humidité. Chaque enrobage 13b, 15b, 17c, 19c, 13d, 15d, 17d, 19d, 13e, 15e, 17e, 19e, pouvant être de même nature ou non et de même épaisseur ou non. A titre d'exemple, l'âme 9b, 9c, 9d, 9e, 9f peut comporter du silicium dopé ou non 11a, 11b, 11c, 11d, 11e, 11f, sur lequel est formé au moins partiellement un enrobage de dioxyde de silicium 13b, 15b, 17c, 19c, 13d, 15d, 17d, 19d, 13e, 15e, 17e, 19e, 21f.

Un procédé de fabrication d'un spiral compensateur 1 pour un résonateur balancier-spiral compensé thermiquement comporte les étapes suivantes :
a) former un spiral comportant une âme 9a, 9b, 9c, 9d, 9e, 9f compensée thermiquement et formée à partir d'au moins un matériau 11a, 11b, 13b, 15b, 11c, 17c, 19c, 11d, 13d, 15d, 17d, 19d, 11e, 13e, 15e, 17e, 19e, 11f, 21f ;
b) revêtir entièrement l'âme 9a, 9b, 9c, 9d, 9e, 9f d'une couche 7 qui est stable à l'humidité afin de rendre le spiral 1 moins sensible aux variations climatiques.

L'étape a) peut être obtenue par un gravage selon le motif souhaité du spiral dans une plaque souhaitée pour former tout ou partie 11a, 11b, 11c, 11d, 11e, 11f, de l'âme 9a, 9b, 9c, 9d, 9e, 9f. Dans l'exemple du silicium cristallin et du quartz, il peut être envisagé un gravage ionique réactif profond, connu sous l'abréviation anglaise DRIE, pour réaliser l'étape a).

Bien entendu, l'étape a) comporte également au moins une deuxième phase d'enrobage partiel ou total 13b, 15b, 17c, 19c, 13d, 15d, 17d, 19d, 13e, 15e, 17e, 19e, 21f du spiral obtenu par le gravage de la première phase pour finir l'âme 9b, 9c, 9d, 9e, 9f. Cette deuxième phase peut, par exemple, consister en une oxydation thermique destinée à former du dioxyde silicium lorsqu'une plaquette de silicium cristallin dopé ou non a été gravée lors de la première phase de l'étape a).

L'étape b) permet de déposer une couche 7 stable à l'humidité selon une épaisseur inférieure à 50 nm et comprise autour de 10 nm. L'étape b) peut être réalisée par exemple par une quelconque méthode dépôt en couche mince comme un dépôt en phase vapeur afin, de déposer du chrome, du titane ou du tantale ou un de leurs alliages qui également sont avantageusement des matériaux électriquement conducteurs et faiblement sensibles aux champs magnétiques.

Il est également possible de choisir le matériau stable à l'humidité en fonction de sa teinte particulière afin d'améliorer son esthétisme dans le cas où la pièce d'horlogerie comporte des parties permettant de voir le spiral comme, par exemple, une pièce d'horlogerie du type « squelette » ou une pièce d'horlogerie avec un fond transparent.

## Revendications

1. Spiral compensateur (1) pour un résonateur balancier-spiral compensé thermiquement comportant une âme (9a, 9b, 9c, 9d, 9e, 9f) formée à partir de plusieurs matériaux non métalliques (11a, 11b, 13b, 15b, 11c, 17c, 19c, 11d, 13d, 15d, 17d, 19d, 11e, 13e, 15e, 17e, 19e, 11f, 21f) comportant du quartz **caractérisé en ce que** l'âme (9a, 9b, 9c, 9d, 9e, 9f) est entièrement revêtue d'une couche (7) électriquement conductrice comportant du chrome, ou du titane ou du tantale, la dite couche (7) électriquement conductrice étant résistante et imperméable à l'humidité afin de rendre le spiral compensateur (1) moins sensible aux variations climatiques lorsque l'humidité est condensée et recueillie sur cette couche (7).

2. Spiral compensateur (1) pour un résonateur balancier-spiral compensé thermiquement comportant une âme (9a, 9b, 9c, 9d, 9e, 9f) formée à partir d'au moins un matériau non métallique (11a, 11b, 13b, 15b, 11c, 17c, 19c, 11d, 13d, 15d, 17d, 19d, 11e, 13e, 15e, 17e, 19e, 11f, 21f) comportant du silicium sur lequel est formé au moins partiellement un revêtement de dioxyde de silicium **caractérisé en ce que** l'âme (9a, 9b, 9c, 9d, 9e, 9f) est entièrement revêtue d'une couche (7) électriquement conductrice comportant du chrome ou du tantale, ladite couche (7) électriquement conductrice étant résistante et imperméable à l'humidité afin de rendre le spiral compensateur (1) moins sensible aux variations climatiques lorsque l'humidité est condensée et recueillie sur cette couche (7), ladite couche (7) étant formée sur le revêtement de dioxyde de silicium qui est interposé entre l'âme et ladite couche (7), de sorte que cette couche électriquement conductrice et étanche à l'humidité protège ce revêtement de dioxyde de silicium.

3. Spiral compensateur (1) pour un résonateur balancier-spiral compensé thermiquement selon la revendication 2 dans lequel le silicium à partir duquel l'âme est formée est du silicium dopé.

4. Spiral compensateur (1) selon l'une des revendications précédentes, **caractérisé en ce que** la couche (7) résistante et imperméable à l'humidité comporte une épaisseur inférieure à 50 nm.

5. Résonateur compensé thermiquement pour une pièce d'horlogerie comportant un balancier **caractérisé en ce que** le balancier coopère avec un spiral compensateur (1) selon une quelconque des revendications précédentes.

## Patentansprüche

1. Kompensierende Unruhfeder (1) für einen thermisch kompensierten gefederten Unruhresonator mit einem Kern (9a, 9b, 9c, 9d, 9e, 9f) aus mehreren nichtmetallischen Materialien (11a, 11b, 13b, 15b, 11c, 17c, 19c, 11d, 13d, 15d, 17d, 19d, 11e, 13e, 15e, 17e, 19e, 11f, 21f), der Quarz umfasst, **dadurch gekennzeichnet, dass** der Kern (9a, 9b, 9c, 9d, 9e, 9f) vollständig mit einer elektrisch leitfähigen Schicht (7) plattiert ist, die Chrom, Titan oder Tantal umfasst, wobei die elektrisch leitfähige Schicht (7) feuchtigkeitsbeständig und -undurchlässig ist, um die kompensierende Unruhfeder (1) weniger empfindlich gegenüber klimatischen Schwankungen zu machen, wenn Feuchtigkeit kondensiert und sich auf dieser Schicht (7) sammelt.

2. Kompensierende Unruhfeder (1) für einen thermisch kompensierten gefederten Unruhresonator mit einem Kern (9a, 9b, 9c, 9d, 9e, 9f) aus mindestens einem nichtmetallischen Material (11a, 11b, 13b, 15b, 11c, 17c, 19c, 11d, 13d, 15d, 17d, 19d, 11e, 13e, 15e, 17e, 19e, 11f, 21f), der Silizium umfasst und auf dem eine Siliziumdioxidplattierung zumindest teilweise ausgebildet ist, besteht, **dadurch gekennzeichnet, dass** der Kern (9a, 9b, 9c, 9d, 9e, 9f) vollständig mit einer elektrisch leitfähigen Schicht (7) plattiert ist, die Chrom oder Tantal umfasst, wobei die elektrisch leitfähige Schicht (7) feuchtigkeitsbeständig und -undurchlässig ist, um die kompensierende Unruhfeder (1) weniger empfindlich gegenüber klimatischen Schwankungen zu machen, wenn Feuchtigkeit kondensiert und sich auf dieser Schicht (7) sammelt, wobei die Schicht (7) auf der Siliziumdioxidplattierung gebildet ist, die zwischen dem Kern und der Schicht (7) angeordnet ist, sodass diese elektrisch leitfähige, feuchtigkeitsundurchlässige Schicht diese Siliziumdioxidplattierung schützt.

3. Kompensierende Unruhfeder (1) für einen thermisch kompensierten gefederten Unruhresonator nach Anspruch 2, wobei das Silizium, aus dem der Kern gebildet ist, dotiertes Silizium ist.

4. Kompensierende Unruhfeder (1) nach einem der vorhergehenden Ansprüche, **dadurch gekennzeichnet, dass** die Schicht (7), die feuchtigkeitsbeständig und -undurchlässig ist, eine Dicke von weniger als 50 nm aufweist.

5. Thermisch kompensierter Resonator für einen Zeitmesser mit einer Unruh, **dadurch gekennzeichnet, dass** die Unruh mit einer kompensierenden Unruhfeder (1) nach einem der vorhergehenden Ansprüche zusammenwirkt.

## Claims

1. A compensating balance spring (1) for a thermally compensated sprung balance resonator comprising a core (9a, 9b, 9c, 9d, 9e, 9f) formed from several non-metallic materials (11a, 11b, 13b, 15b, 11c, 17c, 19c, 11d, 13d, 15d, 17d, 19d, 11e, 13e, 15e, 17e, 19e, 11f, 21f) comprising quartz, **characterised in that** the core (9a, 9b, 9c, 9d, 9e, 9f) is entirely plated with an electrically conductive layer (7) comprising chromium, or titanium or tantalum, said electrically conductive layer (7) being resistant and impervious to humidity in order to render the compensating balance spring (1) less sensitive to climatic variations when humidity condenses and collects on this layer (7).

2. A compensating balance spring (1) for a thermally compensated sprung balance resonator comprising a core (9a, 9b, 9c, 9d, 9e, 9f) formed from at least one non-metallic material (11a, 11b, 13b, 15b, 11c, 17c, 19c, 11d, 13d, 15d, 17d, 19d, 11e, 13e, 15e, 17e, 19e, 11f, 21f) comprising silicon on which a silicon dioxide plating is at least partially formed, **characterised in that** the core (9a, 9b, 9c, 9d, 9e, 9f) is entirely plated with an electrically conductive layer (7) comprising chromium or tantalum, said electrically conductive layer (7) being resistant and impervious to humidity in order to render the compensating balance spring (1) less sensitive to climatic variations when humidity condenses and collects on this layer (7), said layer (7) being formed on the silicon dioxide plating that is interposed between the core and said layer (7), such that this electrically conductive, humidityimpervious layer protects this silicon dioxide plating.

3. The compensating balance spring (1) for a thermally compensated sprung balance resonator according to claim 2, in which the silicon from which the core is formed is doped silicon.

4. The compensating balance spring (1) according to any of the preceding claims, **characterised in that** the layer (7) that is resistant and impervious to humidity has a thickness of less than 50 nm.

5. A thermally compensated resonator for a timepiece comprising a balance, **characterised in that** the balance cooperates with a compensating balance spring (1) according to any of the preceding claims.
